## Europäisches Patentamt
## European Patent Office
## Office européen des brevets

(11) Publication number: **0 050 972**
**B1**

(12) **EUROPEAN PATENT SPECIFICATION**

(45) Date of publication of patent specification: **22.05.85**

(21) Application number: **81305009.3**

(22) Date of filing: **23.10.81**

(51) Int. Cl.⁴: **H 01 L 21/88,** H 01 L 21/306

(54) Method of manufacturing a semiconductor device with an interconnection electrode layer.

(30) Priority: **28.10.80 JP 150991/80**

(43) Date of publication of application:
**05.05.82 Bulletin 82/18**

(45) Publication of the grant of the patent:
**22.05.85 Bulletin 85/21**

(84) Designated Contracting States:
**DE FR GB**

(56) References cited:
**DE-A-2 727 788**
**DE-B-2 536 718**
**US-A-4 269 654**

**IBM TECHNICAL DISCLOSURE BULLETIN Vol.
19, No. 9, February 1977 New York A. BONDUR
et al. "Step Coverage Process with Projection
Printing and Reactive Ion Etching"**

(73) Proprietor: **Kabushiki Kaisha Toshiba
72, Horikawa-cho Saiwai-ku
Kawasaki-shi Kanagawa-ken 210 (JP)**

(72) Inventor: **Shima, Shohei
102, Aparuto-Kayama, 664-1 Ikuta
Tama-ku Kawasaki-shi (JP)**

(74) Representative: **Freed, Arthur Woolf et al
MARKS & CLERK 57-60 Lincoln's Inn Fields
London WC2A 3LS (GB)**

# Description

This invention relates to a method for manufacturing a semiconductor device and in particular an improved method for forming thin layers on a semiconductor substrate.

Recently, a multi-interconnection structure has more often been adopted with the advent of a high-density and high-integrated version of semiconductor device. One important task in the formation of the multi-interconnection structure is to prevent the disconnection of the interconnection electrode layer due to a possible stepped configuration. An etching technique is used in the formation of such multi-interconnection structure. With a recent advance of a microminiaturization technique the etching technique is shifted from a wet process using a liquid etchant to a dry process utilizing plasma. Recently, a dry etching method has been used in the formation of a contact hole and through hole in an insulating layer as well as the patterning of a metal electrode layer. The dry etching process permits a thin layer such as an insulating layer and metal layer to be formed without undercutting.

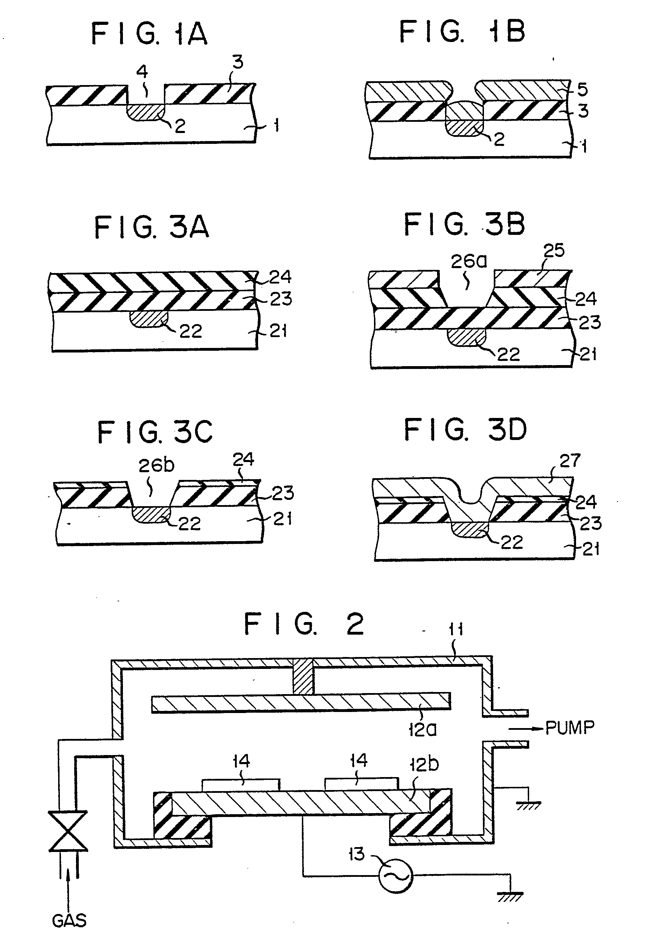

A step for forming a contact hole by a dry method in an insulating layer on a semiconductor substrate and step for forming an interconnection electrode layer on the insulating layer will be explained by referring to Figs. 1A and 1B. In Fig. 1A, an active region such as a diffusion layer is formed in a semiconductor substrate and then a contact hole 4 is formed by a dry etching method with a resist film as a mask. The side wall of the contact hole 4 extends vertically as shown in Fig. 1A. If, as shown in Fig. 1B, a metal layer 5, i.e. a first interconnection layer, is formed by a vacuum evaporation or sputtering method on the insulating layer, metal will not be deposited on the side wall of the contact hole 4, resulting in a so-called "disconnection" phenomenon. As a countermeasure against such phenomenon, a method has been proposed in which metal is deposited on a substrate, while heating the substrate, to cause the mobility of the deposited metal atoms to be enhanced to permit adequate metal to be deposited on the side wall of the contact hole 4. According to this method, however, an irregular surface is likely to be formed on the interconnection electrode layer, making it unsuitable for the microminiaturization of the semiconductor structure.

The disconnection phenomenon occurs on an interconnection electrode layer on a contact hole, on an interconnection electrode layer on the through hole of the insulating layer between the layers of the multi-interconnection structure, and on an upper interconnection electrode layer on the discontinuity area of a lower interconnection electrode layer.

From DE—A—2 727 788 a method is known for selectively removing a silicon nitride layer by reactive ion etching using a gas containing carbon-halogen bonds in order to form an opening with sloped side walls. According to this method an electrode can be deposited on this silicon nitride layer without disconnection.

An object of this invention is to provide a method for manufacturing a semiconductor device for preventing a possible disconnection of an interconnection electrode layer deposited on other layers.

Another object of this invention is to provide a semiconductor device having a multi-interconnection structure of high reliability.

According to this invention there is provided a method for manufacturing a semiconductor device, comprising the steps of forming a first material layer on a semiconductor substrate, forming a second material layer made of silicon nitride on the first material layer, selectively removing the second material layer, and selectively removing the first material layer with the second material layer as a mask, characterized in that the second material layer is selectively removed by a reactive ion etching method using a gas containing hydrogen and carbon-halogen bonds, to form an opening with a sloped side wall, and said first material layer is selectively removed by an etching method to form an opening with a sloped side wall, the etching method permitting the first and second material layers to be etched away.

This invention can be more fully understood from the following detailed description when taken in conjunction with the accompanying drawings, in which:

Figs. 1A and 1B are cross-sectional views showing the steps of forming a conventional interconnection electrode layer;

Fig. 2 is a cross-sectional view showing a reactive ion etching apparatus as used in the process of this invention;

Figs. 3A to 3D are cross-sectional views showing the process of one method of this invention;

Figs. 4A to 4E are cross-sectional views showing the process of another method of this invention; and

Figs. 5A to 5E are cross-sectional views showing the process of another method of this invention.

After various research into a dry etching technique, the inventors have discovered that, if with a resist pattern as a mask a silicon nitride layer is subjected to a reactive ion etching using a gas containing hydrogen and carbon-halogen bonds to selectively remove the silicon nitride layer, the side wall of a resultant opening in the silicon nitride layer is sloped with respect to a horizontal plane. This invention is based on this discovery. That is, this discovery is applied to the formation of an interconnection electrode layer on the material layer with an opening. With the silicon nitride layer whose opening has a sloped side wall as a mask, an underlying material layer is selectively removed by an etching method whereby both the silicon nitride layer and the underlying material layer can be etched away, to automatically form a sloped side wall in a resultant opening in the material layer. If a conductive material is deposited directly on the material layer or on an insulating layer overlying the material layer, followed by patterning, an interconnection electrode layer is formed on or above the opening without producing any disconnection.

The gas containing hydrogen and carbon-halogen bonds as an etchant may be a mixture gas of a hydrogen gas with a gas of $CF_4$, $C_2F_6$, $C_3F_8$, $CCl_4$, $CH_3Br$ or the like. A $CHF_3$ gas may also be used. Where use is made of a gas mixture of a hydrogen gas with a gas containing carbon-halogen bonds, an amount of hydrogen gas is preferably 10 to 40% based on the whole amount of the gas mixture. In this case, it is possible, to obtain a silicon nitride layer whose opening has a sloped side wall with an inclination angle of 60° to 70°.

The reactive ion etching is performed by an apparatus as shown in Fig. 2. A workpiece 14 is placed on one (12b) of a pair of parallel, planar electrodes 12a, 12b which are mounted within an etching chamber 11. The electrode 12b is connected to a high frequency power generator.

As the etching method whereby both the silicon nitride and the underlying material can be etched away, use may be made of any etching method such as a plasma etching, reactive ion etching, sputtering etching, wet etching method, in which a proper etchant is used. For example, a gas mixture of a $H_2$ gas with a fluorocarbon gas such as $CF_4$ may be used as an etchant for an underlying material of silicon oxide; a fluoro-carbon gas such as $CF_4$, as an etchant for an underlying material of poly-Si; and a chloro-carbon gas such as $CCl_4$ as an etchant for an underlying material of aluminium.

If a reactive ion etching method using a gas mixture of a $H_2$ gas with a $CF_4$ gas as an etchant is adopted with silicon oxide used as the underlying material, the silicon nitride layer is selectively removed by a first etching on an etching device and then a second etching is performed on the same device under the similar conditions by causing an amount of $H_2$ to be increased or decreased to, for example, 10 to 30% i.e. an amount permitting both the silicon nitride layer and the underlying material layer to be etched away. As set out in more detail in connection with the following Examples, the method of this invention can be applied to the formation of an interconnection electrode layer on an insulating layer with a contact hole or a through hole or the formation of a second interconnection electrode layer overlying the first interconnection electrode layer having a discontinuity area with an insulating film therebetween. According to this invention an opening such as a contact hole, through hole and discontinuity in the interconnection electrode layer can be formed to have a sloped side wall, preventing a possible disconnection of an interconnection electrode which is formed on the opening. As a result, it is possible to obtain a semiconductor device having a multi-interconnection structure of high reliability.

The embodiment of this invention will be explained below by reference to the accompanying drawings.

## Example 1

As shown in Fig. 3A, a first insulating layer such as a silicon oxide film 23 is wholly coated on a semiconductor substrate 21 in which an active region 22 such as a diode and transistor is formed and then a silicon nitride film 24 is formed by a plasma CVD method using, for example, $SiH_4$ and $NH_3$. As shown in Fig. 3B, with a resist 25 as a mask a silicon nitride film 24 is etched, by a reactive ion etching method (using a device as shown in Fig. 2), under the conditions of 25 cm$^3$/min of $CF_4$, 9 cm$^3$/min. of $H_2$, 1.33 Pa (0.01 Torr) of pressure and 0.25 W/cm$^2$ of a high frequency power. In this step, a hole 26a is formed in the silicon nitride film 24 and has a taper of 60° to 70°. After the resist 25 is removed, a reactive ion etching is effected. If at this time both the silicon oxide film 23 and nitride film 24 are etched in a mixed gas under the conditions such as 20 cm$^3$/min. of $CF_4$ and 10 cm$^3$/min. of $H_2$, since a sloped side wall has already been formed in the hole 26a, the hole 26a is widened with the continued etching to form a tapered contact hole 26b as shown in Fig. 3C, which would not otherwise be formed by an ordinary etching with a resist as a mask. When the selective etching of the silicon oxide film 23 is completed, the silicon nitride film 24 is thinly left on the resultant structure, but it may be completely removed dependent upon the etching requirements. As shown in Fig. 3D, an interconnection electrode layer 27 made of, for example, aluminium is formed on the resultant structure. Since in this case the taper is formed on the side wall of the contact hole, no disconnection of the interconnection layer 27 occurs due to a possible stepped configuration. Although, in this Example, the resist 25 is removed after the silicon nitride film 24 is selectively etched, the silicon oxide film 23 may be etched with the resist 25 left as it is.

## Example 2

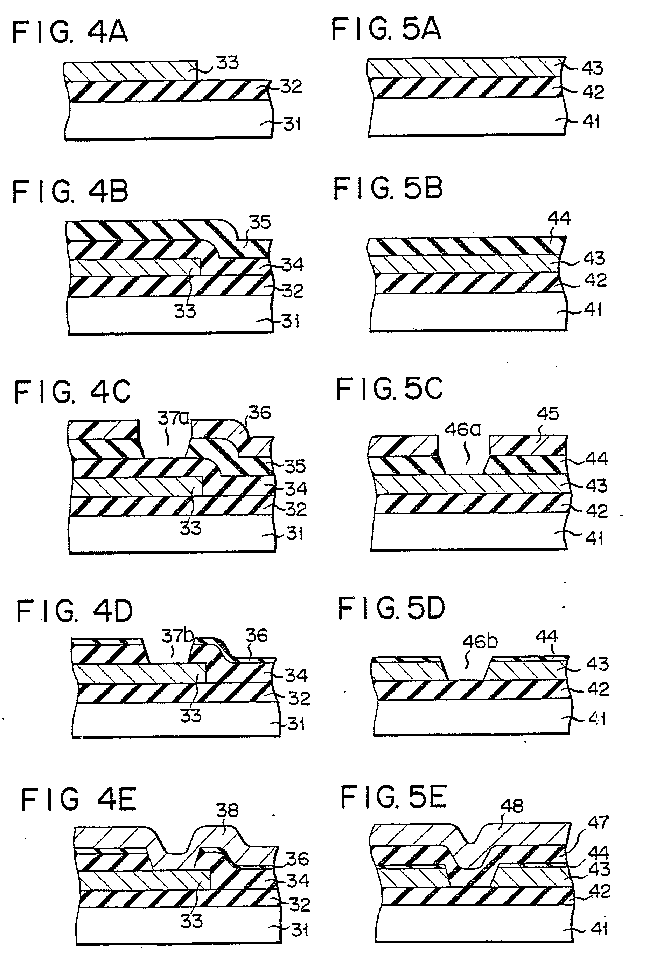

In this Example, this invention is applied to the formation of a through hole in a multi-interconnection structure. As shown in Fig. 4A, an insulating layer 32 is formed on a semiconductor substrate 31 and a first interconnection layer 33 is formed on the insulating layer 32. As shown in Fig. 4B, for example, a silicon oxide film 34 is formed as an insulating layer and then a silicon nitride film 35 is coated on the surface of the resultant structure. As shown in Fig. 4C, with a resist 36 as a mask a through hole 37a is formed, as in Example 1, in a predetermined area of the silicon nitride film 35. If, as shown in Fig. 4D, etching is effected as in Example 1 after the resist 36 is removed, a tapered through hole 37b is formed in the silicon oxide film (the insulating layer) as in Example 1. As shown in Fig. 4E, a second interconnection layer 38 is formed on the surface of the resultant structure. In this case, no discontinuity occurs due to a possible stepped configuration.

Example 3

In this Example, this invention is applied to the formation of an interconnection layer per se. As shown in Fig. 5A, a first interconnection layer 43 made of, for example, poly-Si or aluminium is formed on an insulating layer 42 overlying a semiconductor substrate 41. As shown in Fig. 5B a silicon nitride film 44 is wholly formed on the surface of the resultant structure. As shown in Fig. 5C, with a resist 45 as a mask the silicon nitride film 44 is etched into a predetermined interconnection pattern to provide, for example, a slit 46a. At this time, the silicon nitride film 44 can be etched such that, as in Examples 1 and 2, the slit 46a has a taper on its side wall. If with the silicon nitride film 44 as a mask the interconnection layer 43 is subjected to a reactive ion etching using, for example, a CF₄ gas for poly-Si or a CCl₄ gas for aluminium, a taper is formed on the side wall of a slit 46b of the interconnection layer 43. When an insulating layer 47 is coated on the surface of the resultant structure and then a second interconnection layer 48 is formed on the surface of the insulating layer 48, no discontinuity of the interconnection layer 48 occurs due to a possible stepped configuration.

## Claims

1. A method for manufacturing a semiconductor device comprising a step of forming a first material (23) layer on a semiconductor substrate (21), a step of forming a second material layer (24) made of silicon nitride on the first material layer (23), a first etching step of selectively removing the second material layer (24), and a second etching step of selectively removing the first material layer (23) with the second material layer (24) as a mask, characterized in that said second material layer (24) is selectively removed by a reactive ion etching method using a gas containing hydrogen and carbon-halogen bonds to form an opening (26a) with a sloped side wall, and said first material layer (23) is selectively removed by an etching method to form an opening (26b) with a sloped side wall, said etching method permitting said first and second materials layers (23, 24) to be etched away.

2. A method according to claim 1, wherein said gas containing hydrogen and carbon-halogen bonds is a gas mixture of CF₄, C₂F₆, C₃F₈, CCl₄ or CF₃Br and H₂ or CHF₃ gas.

3. A method according to claim 1, wherein said gas containing hydrogen and carbon-halogen bonds is a gas mixture of CF₄, C₂F₆, C₃F₈, CCl₄ or CF₃Br and H₂ in which the volume of H₂ is 10 to 40 volume percent of the total volume of said gas mixture.

4. A method according to any one of claims 1 to 3 in which said first material layer (23) is a silicon oxide layer and said second etching step is performed by a reactive ion etching method using a gas mixture of a fluorocarbon gas and H₂ gas as an etchant.

5. A method according to any one of claims 1 to 3 in which said first material layer (23) is an aluminium layer and said second etching step is performed by a dry etching method using a chloro-carbon gas as an etchant.

6. A method according to any one of claims 1 to 3, in which said first material layer (23) is a polycrystalline silicon layer and said second etching step is performed by a dry etching method using a fluorocarbon gas as an etchant.

## Revendications

1. Procédé de fabrication d'un dispositif semiconducteur consistant à former une première couche de matériau (23) sur un substrat semiconducteur (21), à former une seconde couche de matériau (24) constituée de nitrure de silicium sur la première couche de matériau (23), à effectuer une première attaque pour retirer sélectivement la seconde couche de matériau (24), et à effectuer une seconde attaque pour retirer sélectivement la première couche de matériau (23) avec la seconde couche de matériau (24) comme masque, caractérisé en ce que la seconde couche de matériau (24) est retirée sélectivement par un procédé d'attaque par ions réactifs en utilisant un gaz contenant de l'hydrogène et des liaisons de carbone-halogène pour former un trou (26a) comportant une paroi latérale inclinée, et en ce que la première couche de matériau (23) est retirée sélectivement par un procédé d'attaque pour former un trou (26b) comportant une paroi latérale inclinée, le procédé d'attaque permettant d'attaquer les première et seconde couches de matériau (23, 24).

2. Procédé selon la revendication 1, caractérisé en ce que le gaz contenant de l'hydrogène et des liaisons de carbone-halogène est un mélange de gaz de CF₄, C₂F₆, C₃F₈, CCl₄ ou de CF₃Br et de H₂ ou de CHF₃ à l'état gazeux.

3. Procédé selon la revendication 1, caractérisé en ce que le gaz contenant de l'hydrogène et des liaisons de carbone-halogène est un mélange de gaz de CF₄, C₂F₆, C₃F₈, CCl₄ ou de CF₃Br et de H₂, dans lequel le volume de H₂ représente 10 à 40% en volume du volume total du mélange de gaz.

4. Procédé selon l'une quelconque des revendications 1 à 3, caractérisé en ce que la première couche de matériau (23) est une couche d'oxyde de silicium et en ce que la seconde attaque est réalisée par un procédé d'attaque par ions réactifs en utilisant un mélange de gaz d'un gaz de fluorure de carbone et d'un gaz de H₂ comme produit d'attaque.

5. Procédé selon l'une quelconque des revendications 1 à 3, caractérisé en ce que la première couche de matériau (23) est une couche d'aluminium et en ce que la seconde attaque est réalisée par un procédé d'attaque à l'état sec en utilisant un gaz de chlorure de carbone comme produit d'attaque.

6. Procédé selon l'une quelconque des revendications 1 à 3, caractérisé en ce que la première couche de matériau (23) est une couche de silicium polycristallin et en ce que la seconde attaque est réalisée par un procédé d'attaque à l'état sec en utilisant un gaz de fluorure de carbone comme produit d'attaque.

**Patentansprüche**

1. Verfahren zur Herstellung einer Halbleitervorrichtung durch Ausbilden einer Schicht (23) aus einem ersten Material auf einem Halbleitersubstrat (21), Ausbilden einer Schicht (24) aus einem aus Siliziumnitrid bestehenden zweiten Material auf der Schicht (23) aus dem ersten Material, eine erste Ätzung zur selektiven Entfernung der Schicht (24) aus dem zweiten Material und eine zweite Ätzung zur selektiven Entfernung der Schicht (23) aus dem ersten Material, wobei die Schicht (24) aus dem zweiten Material als Maske dient, dadurch gekennzeichnet, daß man die Schicht (24) aus dem zweiten Material selektiv durch reaktive Ionenätzung unter Verwendung eines Wasserstoff- und Kohlenstoff-Halogen-Bindungen enthaltenden Gases unter Bilding einer Öffnung (26a) mit geneigter Seitenwand und die Schicht (23) aus dem ersten Material selektiv mit Hilfe eines Ätzungsverfahrens unter Bildung einer Öffnung (26b) mit geneigter Seitenwand entfernt, wobei das Ätzungsverfahren eine Wegätzung der Schichten (23, 24) aus dem ersten und zweiten Material ermöglicht.

2. Verfahren nach Anspruch 1, dadurch gekennzeichnet, daß man als Wasserstoff- und Kohlenstoff-Halogen-Bindungen enthaltendes Gas ein Gemisch aus $CF_4$, $C_2F_6$, $C_3F_8$, $CCl_4$ oder $CF_3Br$ und $H_2$ oder gasförmiges $CHF_3$ verwendet.

3. Verfahren nach Anspruch 1, dadurch gekennzeichnet, daß man als Wasserstoff- und Kohlenstoff-Halogen-Bindungen enthaltendes Gas ein Gasgemisch aus $CF_4$, $C_2F_6$, $C_3F_8$, $CCl_4$ oder $CF_3Br$ und $H_2$ verwendet, wobei das $H_2$-Volumen 10 bis 40 Vol.-% des Gesamtvolumens des Gasgemischs ausmacht.

4. Verfahren nach einem der Ansprüche 1 bis 3, dadurch gekennzeichnet, daß es sich bei der Schicht (23) aus dem ersten Material um eine Siliziumoxidschicht handelt und daß man die erste Ätzung als reaktive Ionenätzung unter Verwendung eines Gasgemischs aus einem Fluorkohlenstoffgas und gasförmigem $H_2$ als Ätzmittel durchführt.

5. Verfahren nach einem der Ansprüche 1 bis 3, dadurch gekennzeichnet, daß es sich bei der Schicht (23) aus dem ersten Material um eine Aluminiumschicht handelt und daß man die zweite Ätzung als Trockenätzung mit Hilfe eines Chlorkohlenstoffgases als Ätzmittel durchführt.

6. Verfahren nach einem der Ansprüche 1 bis 3, dadurch gekennzeichnet, daß es sich bei der Schicht (23) aus dem ersten Material um eine polykristalline Siliziumschicht handelt und daß man die zweite Ätzung als Trockenätzung unter Verwendung eines Fluorkohlenstoffgases als Ätzmittel durchführt.

FIG. 1A

FIG. 1B

FIG. 3A

FIG. 3B

FIG. 3C

FIG. 3D

FIG. 2

FIG. 4A

FIG. 5A

FIG. 4B

FIG. 5B

FIG. 4C

FIG. 5C

FIG. 4D

FIG. 5D

FIG 4E

FIG. 5E